# EUROPEAN PATENT APPLICATION

(11) **EP 1 361 608 A2**
(43) Date of publication of application: **12.11.2003**
(21) Application number: 03101211.5
(22) Date of filing: 01.05.2003
(51) Int. Cl.: H01L 21/768, H01L 23/532, G06F 9/00

(54) **Providing electrical connection between an active region and a conductive layer in a semiconductor device using carbon nanotubes**

(30) Priority: 10.05.2002 US 143223
(71) Applicant: Texas Instruments Incorporated, Dallas, Texas 75251 (US)
(72) Inventor: Haase, Gad S., 75093, Plano (US)
(74) Representative: Holt, Michael

(57) **Abstract**

In one embodiment of the present invention, a semiconductor device within an integrated circuit includes an active region (22) associated with a contact structure(40) of the semiconductor device (10). The semiconductor device (10) also includes a conductive layer (34) providing electrical conductivity between the contact structure (40) of the semiconductor device (10) and one or more other semiconductor devices within the integrated circuit. The semiconductor device (10) also includes a number of carbon nanotubes (32) connected to the active region (22) at first ends of the carbon nanotubes (44), connected to the conductive layer (34) at second ends (48) of the carbon nanotubes (32), and extending within a via (24) of the contact structure (40) from the active region (22) to the conductive layer (34) to provide electrical conductivity between the active region (22) and the conductive layer (34).

## Description

### TECHNICAL FIELD OF THE INVENTION

This invention relates generally to semiconductor devices, and more particularly to providing electrical conductivity between an active region and a conductive layer in a semiconductor device using carbon nanotubes.

### BACKGROUND OF THE INVENTION

An integrated circuit includes a number of semiconductor devices. An electrode or other contact structure of a semiconductor device may include a via between an active region and a conductive layer of the semiconductor device. To provide electrical conductivity between the active region and the conductive layer, a barrier material such as titanium may be deposited to cover the walls of the via, a titanium nitride film may be deposited over the barrier material, and the via may be filled with a metal such as tungsten using a chemical vapor deposition (CVD) technique. Failure to adequately cover the walls of the via with the barrier material or to adequately deposit the titanium nitride film over the barrier material, however, may result in incomplete deposition of the tungsten within the via.

Additionally, filling of the via with a metal such as tungsten may be highly dependent on the shape of the via (e.g., tapering and smoothness of the walls). As the aspect ratio of the contact structure increases, filling the via becomes increasingly difficult and unreliable, sometimes resulting in voids that break the continuity of electrical conductivity through the via, undesirable heating within the contact structure, and other problems. Furthermore, these methods generally require chemical mechanical polishing (CMP) after filling the via, an expensive and sometimes problematic process to remove and smooth the top surface of the deposited metal. For these or other reasons, filling of first contact level vias with metals such as tungsten is a limiting factor in reducing the cross-sectional diameter of contact structures. Future silicon-based technologies may require narrower contact structures with smaller inter-structure separation and, therefore, an alternative to current techniques.

### SUMMARY OF THE INVENTION

According to the present invention, disadvantages and problems associated with previous techniques for providing electrical conductivity between an active region and a conductive layer in a semiconductor device may be reduced or eliminated.

In one embodiment of the present invention, a semiconductor device within an integrated circuit includes an active region associated with a contact structure of the semiconductor device. The semiconductor device also includes a conductive layer providing electrical conductivity between the contact structure of the semiconductor device and one or more other semiconductor devices within the integrated circuit. The semiconductor device also includes a number of carbon nanotubes connected to the active region at first ends of the carbon nanotubes, connected to the conductive layer at second ends of the carbon nanotubes, and extending within a via of the contact structure from the active region to the conductive layer to provide electrical conductivity between the active region and the conductive layer.

Particular embodiments of the present invention may provide one or more technical advantages. For example, certain embodiments may provide, within an electrode or other contact structure of a semiconductor device, electrical conductivity between an active region and a conductive layer using carbon nanotubes extending through a via between the active region and the conductive layer. Carbon nanotubes, particularly multi-walled carbon nanotubes, may provide conductivity similar to the conductivity of metals such as tungsten. For example, a via approximately 375nm high and approximately 120nm across that is filled with hexagonally packed, multi-walled carbon nanotubes that are approximately 9nm in diameter may give rise to a resistance of approximately 30µ in the direction of the axis of the carbon nanotubes. In addition, carbon nanotubes may be more robust than metals such as tungsten, at least in part because each carbon nanotube may be grown as a single molecule extending from the active region to the conductive layer. Use of carbon nanotubes may reduce or eliminate voids that break the continuity of electrical conductivity between the active region and the conductive layer, thereby reducing or eliminating undesirable heating within the contact structure and increasing reliability of the associated semiconductor device.

In certain embodiments, using carbon nanotubes according to the present invention may permit a decrease in the cross-sectional diameter of electrodes or other contact structures within semiconductor devices without sacrificing continuity in electrical conductivity or reliability. This may be beneficial, for example, because the trend toward increasingly dense integrated circuits requires smaller contact structures with smaller inter-structure separation. In addition, use of carbon nanotubes according to the present invention may eliminate the need to deposit barrier materials such as titanium, overlying materials such as titanium nitride film, or other materials associated with deposition of tungsten within vias. Furthermore, additional process steps associated with deposition of metals such as tungsten in vias, such as CMP to remove excess metal from the top of the contact structure, may be eliminated.

Systems and methods incorporating one or more of these or other technical advantages may be well suited for modern integrated circuit fabrication. Certain embodiments of the present invention may provide all, some, or none of the above advantages. Certain embodiments may provide one or more other technical advantages, one or more of which may be readily apparent to those skilled in the art from the figures, descriptions, and claims included herein.

### BRIEF DESCRIPTION OF THE DRAWINGS

For a more complete understanding of the present invention and features and advantages thereof, reference is now made to the following description, taken in conjunction with the accompanying drawings, in which:
FIGURE 1 illustrates an example semiconductor device within an integrated circuit, in which carbon nanotubes provide electrical conductivity between an active region and a conductive layer;
FIGURE 2 illustrates an example contact structure of a semiconductor device in which carbon nanotubes provide electrical conductivity between an active region and a conductive layer;
FIGURE 3 illustrates example carbon nanotubes, viewed from above a contact structure, that are used to provide electrical conductivity between an active region and a conductive layer in a semiconductor device; and
FIGURE 4 illustrates an example method for providing electrical conductivity between an active region and a conductive layer in a semiconductor device using carbon nanotubes.

### DESCRIPTION OF EXAMPLE EMBODIMENTS

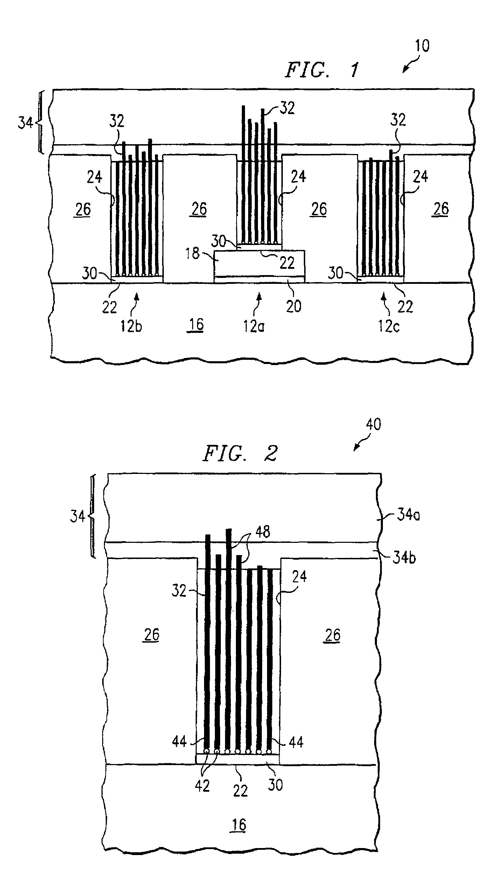

FIGURE 1 illustrates an example semiconductor device 10 within an integrated circuit, in which carbon nanotubes provide electrical conductivity between an active region and a conductive layer. The integrated circuit may be a digital signal processor (DSP) or any other suitable type of integrated circuit. In the illustrated example embodiment, semiconductor device 10 is a field effect transistor (FET), but the present invention contemplates semiconductor device 10 being of any suitable type.

Semiconductor device 10 may include one or more contact structures such as, in this example, a gate electrode 12a, a source electrode 12b, and a drain electrode 12c, formed on a silicon or other substrate 16. Gate electrode 12a may include a polysilicon or other suitable conductive material 18 and an underlying gate oxide layer 20. Electrodes 12 may each include an active region 22 and associated via 24, defined for example by surrounding silicon dioxide or other dielectric 26. Active region 22 may include a thin layer 30 of tungsten or other suitable conductive material preferentially deposited on substrate 16 (which may include an immersed layer of cobalt silicide, nickel silicide, titanium silicide, or another suitable material for desired Ohmic contact). In a particular example embodiment, via 24 may be approximately 1000Å across and approximately 3000-10,000Å high, but the present invention contemplates via 24 being of any appropriate size according to particular needs. Semiconductor device 10 also includes a number of carbon nanotubes 32, grown from corresponding catalyst nanoparticles deposited on active region 22 (on layer 30 for example), extending within vias 24 from active regions 22 to a conductive layer 34 to provide electrical conductivity between active region 22 and conductive layer 34. In a particular example embodiment, millions of carbon nanotubes 32 may be grown within a single via 24. Although layer 30 may be considered part of active region 22 for purposes of this description, the present invention contemplates active region 22 without layer 30. Furthermore, those skilled in the art will appreciate that reference to carbon nanotubes 32 being "coupled to" active region 22 or "extending between" active region 22 and conductive layer 34 encompasses carbon nanotubes 32 being coupled to and extending from corresponding catalyst nanoparticles deposited on active region 22 (for example, on layer 30). (As those skilled in the art will recognize, multiple carbon nanotubes 32 may be grown in certain circumstances from a single catalyst nanoparticle 42.)

FIGURE 2 illustrates an example contact structure 40 of semiconductor device 10 in which carbon nanotubes 32 provide electrical conductivity between active region 22 and conductive layer 34. In one embodiment, contact structure 40 may include an electrode 12 as described above, but contact structure 40 may be any suitable contact structure according to particular needs. Contact structure 40 includes catalyst nanoparticles 42 deposited on active region 22 (on layer 30 for example) to facilitate growth of carbon nanotubes 32 within via 24. Although the prefix "nano" is used throughout this description with reference to carbon nanotubes 32 and catalyst nanoparticles 42, the use of this prefix is not meant to imply any particular size for these components; carbon nanotubes 32 and catalyst nanoparticles 42 may have any appropriate size according to particular needs. Catalyst nanoparticles 42 may be deposited using a variety of techniques, and the present invention contemplates any of these techniques.

In one example embodiment, as described above, active region 22 may include a thin layer 30 of tungsten or other suitable conductive material preferentially deposited on substrate 16 (which may include an immersed layer of cobalt silicide, nickel silicide, titanium silicide, or another suitable material for desired Ohmic contact). Layer 30 may be preferentially deposited on substrate 16 within via 24, for example, using a CVD technique. As just an example, the thickness of layer 30 may in certain embodiments range from approximately 150Å to approximately 400Å. Semiconductor device 10 may be exposed at elevated temperatures to one or more CVD precursors to facilitate the formation of catalyst nanoparticles 42, such as nucleation crystallites for example, on or within layer 30. Suitable CVD precursors may include nickel; cobalt; alloys of nickel, cobalt, cerium, or palladium; iron or iron oxide particles; or any other CVD precursors suitable for facilitating the formation of catalyst nanoparticles 42. In one embodiment, a layer 30 that includes tungsten or any other conductive material that can be preferentially deposited on substrate 16 within via 24 can be used if it is more likely for the CVD precursors to dissociate and form catalyst nanoparticles 42 on top of layer 30 (the floor of via 24) than on dielectric 26 (the walls of via 24). The exposure of semiconductor device 10 to the one or more CVD precursors may be limited to a predetermined time to create catalyst nanoparticles 42 of a desired size. For example, as the exposure time increases, the average diameter of catalyst nanoparticles 42 may increase. In a particular example embodiment, the diameters of catalyst nanoparticles 42 may range from approximately 2nm to approximately 15nm, with an optimum size of approximately 9nm, although the present invention contemplates catalyst nanoparticles 42 of any suitable size.

In an alternative embodiment, layer 30 is not deposited on substrate 16, and catalyst nanoparticles 42 form directly on substrate 16 when semiconductor device 10 is exposed at elevated temperatures to one or more CVD precursors. In yet another alternative embodiment, semiconductor device 10 with etched vias 24 may be dipped in one or more aqueous solutions of metal-containing molecules (FERROCENE for example) to form catalyst nanoparticles 42, then exposed to a thermal treatment, such that only substrate 16 (the floor of via 24) will support metal or metal oxide catalyst nanoparticles 42.

Catalyst nanoparticles 42 are used to facilitate growth of carbon nanotubes 32, one or more carbon nanotubes 32 being associated with a corresponding catalyst nanoparticle 42. (As those skilled in the art will recognize, multiple carbon nanotubes 32 may be grown in certain circumstances from a single catalyst nanoparticle 42.) In one embodiment, for example, a gas or plasma enhanced CVD process may be performed on semiconductor device 10, exposing catalyst nanoparticles 42 (and after carbon nanotubes 32 begin growing from catalyst nanoparticles 42, exposing the resulting growing carbon nanotubes 32) to carbon containing gases or plasma at elevated temperatures. Such carbon containing gases may include methane, acetylene, or any other gas appropriate for growing carbon nanotubes 32, according to particular needs. As an example, iron or iron oxide catalyst nanoparticles 42 deposited on an oxidized silicon or aluminum substrate, after being exposed to an appropriate carbon-containing gas, have resulted in carbon nanotubes 32 approximately 5nm to approximately 100nm in diameter and up to approximately 10µm in height. The growth of carbon nanotubes 32 using gas or plasma enhanced CVD techniques may occur, for example, at temperatures ranging from approximately 400°C to approximately 600°C, which is within the thermal budget of most integrated circuit fabrication processes of interest. The length of time the growing carbon nanotubes 32 are exposed to the gas or plasma under such conditions typically determines the ultimate height of carbon nanotubes 32. The resulting carbon nanotubes 32 may have a distribution of heights despite being exposed to the gas or plasma under equivalent conditions for equivalent lengths of time.

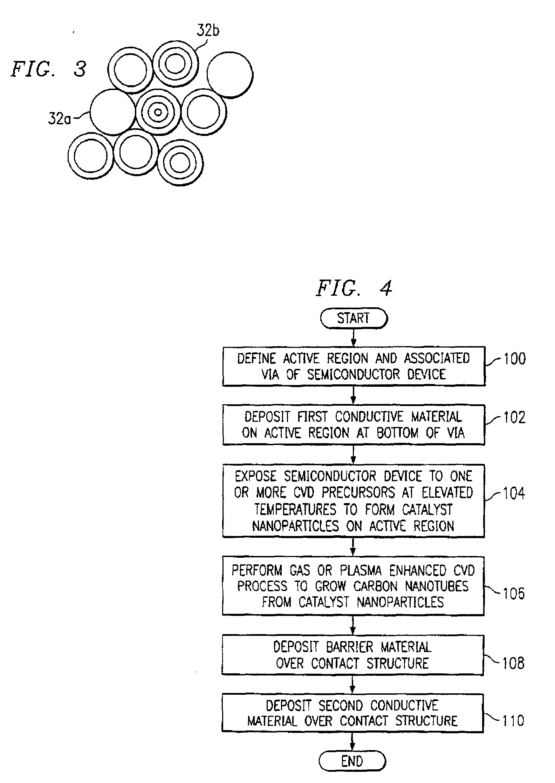

Carbon nanotubes 32 may grow substantially perpendicular to active region 22, being coupled to corresponding catalyst nanoparticles 42 at first ends 44 of carbon nanotubes 32. FIGURE 3 illustrates example carbon nanotubes 32, viewed from above contact structure 40, that are used to provide electrical conductivity between active region 22 and conductive layer 34 of semiconductor device 10. The present invention contemplates growing single-walled carbon nanotubes 32a, multi-walled carbon nanotubes 32b, or any combination of the two within via 24. The temperature, gas or plasma, or other conditions to which catalyst nanoparticles 42 are exposed during the enhanced CVD process may determine whether single-walled carbon nanotubes 32a, multi-walled carbon nanotubes 32b, or both are ultimately grown and, where both are grown, the ratio of multi-walled carbon nanotubes 32b to single-walled carbon nanotubes 32a. In a particular embodiment, it may be desirable for carbon nanotubes 32 to provide conductivity similar to that of a simple metal such as tungsten. As illustrated in FIGURE 3, multi-walled carbon nanotubes 32b result in a greater density of carbon nanotubes 32. This characteristic may make the inclusion of multi-walled carbon nanotubes 32b preferable in that the increased density may provide conductivity more similar to a simple metal than less dense single-walled carbon nanotubes 32a. Furthermore, single-walled carbon nanotubes 32a may be more difficult to grow because they generally must be grown at higher temperatures than multi-walled carbon nanotubes 32b, which may cause the thermal budget for the applicable integrated circuit fabrication process to be exceeded. It may also be more difficult to control folding of single-walled carbon nanotubes 32a than for multi-walled carbon nanotubes 32b, where specific folding may cause particular single-walled carbon nanotubes 32a to behave as a semiconductor.

Returning to FIGURE 2, conductive layer 34 may be deposited over contact structure 40 to provide electrical conductivity between contact structure 40 and one or more other semiconductor devices within the associated integrated circuit. Conductive layer 34 may include copper or any other suitable conductive material 34a. It may be desirable to prevent seepage of conductive material 34a into dielectric 26 surrounding via 24, which may cause short circuits and other problems. In one embodiment, a barrier material 34b may be deposited over contact structure 40, before deposition of conductive material 34a, to substantially prevent seepage of conductive material 34a into dielectric 26. Barrier material 34b may be deposited such that it substantially surrounds second ends 48 of carbon nanotubes 32, possibly extending into via 24 so as to substantially surround second ends 48 even of any carbon nanotubes 32 whose second ends 48 do not project out of via 24. Barrier material 34b may include tantalum nitride or any other material suitable for substantially preventing seepage of conductive material 34a into dielectric 26, according to particular needs. Additional process steps associated with deposition of metals such as tungsten in via 24, such as CMP to remove excess metal from the top of contact structure 40, may be eliminated. This may be in part because the growth of carbon nanotubes 32 may be controlled to control the ultimate height of carbon nanotubes 32 and in part because extension of second ends 48 of carbon nanotubes 32 into conductive layer 34 may actually be desirable in providing electrical conductivity between active region 22 and conductive layer 34.

In one embodiment, exposing the walls of via 24 to the gas or plasma used during CVD growth of carbon nanotubes 32 may incidentally result in the formation of a barrier material along the walls of via 24. For example, if dielectric 26 includes silicon dioxide and gas used during CVD growth of carbon nanotubes 32 includes a carbon-containing gas, the barrier material formed along the walls may include silicon carbide. This barrier material, in addition to barrier material 34b, may substantially prevent seepage of conductive material 34a into dielectric 26 surrounding via 24.

Particular embodiments of the present invention may provide one or more technical advantages. For example, certain embodiments may provide, within an electrode 12 or other contact structure 40 of semiconductor device 10, electrical conductivity between active region 22 and conductive layer material 34 using carbon nanotubes 32 extending through via 24 between active region 22 and conductive layer material 34. Carbon nanotubes 32, particularly multi-walled carbon nanotubes 32b, may provide conductivity similar to the conductivity of metals such as tungsten. For example, a via 24 that is approximately 375nm high and approximately 120nm across and that is filled with hexagonally packed, multi-walled carbon nanotubes 32b that are approximately 9nm in diameter may give rise to a resistance of approximately 30µ in the direction of the axis of the carbon nanotubes 32. Carbon nanotubes 32 may be packed substantially hexagonally, as is most desirable, or, as is more likely, in an essentially random manner depending on the conditions under which catalyst nanoparticles 42 are formed and one or more corresponding carbon nanotubes 32 are grown. In addition, carbon nanotubes 32 may be more robust than metals such as tungsten, at least in part because each carbon nanotube 32 may be grown as a single molecule extending from active region 22 to conductive layer material 34. Use of carbon nanotubes 32 may reduce or eliminate voids that break the continuity of electrical conductivity between active region 22 and conductive layer material 34, thereby reducing or eliminating undesirable heating within contact structure 40 and increasing reliability of associated semiconductor device 10.

In certain embodiments, using carbon nanotubes 32 according to the present invention may permit a decrease in the cross-sectional diameter of electrode 12 or other contact structures 40 within semiconductor devices without sacrificing continuity in electrical conductivity or reliability. This may be beneficial, for example, because the trend toward increasingly dense integrated circuits requires smaller contact structures 40 with smaller inter-structure separation. In addition, use of carbon nanotubes 32 according to the present invention may eliminate the need to deposit barrier materials such as titanium, overlying materials such as titanium nitride film, or other materials associated with deposition of metals such as tungsten within vias 24. Furthermore, additional process steps associated with deposition of metals such as tungsten in vias 24, such as CMP to remove excess metal from the top of the contact structure 40, may be eliminated.

FIGURE 4 illustrates an example method for providing electrical conductivity between active region 22 and conductive layer 34 in semiconductor device 10 using carbon nanotubes 32. At step 100, active region 22 and associated via 24 of contact structure 40 are defined, for example, through formation and subsequent processing of dielectric 26. At step 102, a thin layer 30 of tungsten or other suitable first conductive material may be preferentially deposited on substrate 16 (which may include an immersed layer of cobalt silicide, nickel silicide, titanium silicide, or another suitable material for desired Ohmic contact) at the bottom of via 24. At step 104, semiconductor device 10 may be exposed to one or more CVD precursors at elevated temperatures to facilitate the formation of catalyst nanoparticles 42 on active region 22 (on layer 30 for example). In one embodiment, catalyst nanoparticles 42 are nucleation crystallites formed on or within layer 30. As described above, suitable CVD precursors may include nickel; cobalt; alloys of nickel, cobalt, cerium, or palladium; iron or iron oxide particles; or any other CVD precursors suitable for facilitating the formation of catalyst nanoparticles 42. In one embodiment, a layer 30 that includes tungsten or any other conductive material that can be preferentially deposited on substrate 16 within via 24 can be used if it is more likely for the CVD precursors to dissociate and form catalyst nanoparticles 42 on top of layer 30 (the floor of via 24) than on dielectric 26 (the walls of via 24). As discussed above, the exposure of semiconductor device 10 to the one or more CVD precursors may be limited to a predetermined time to create catalyst nanoparticles 42 of a desired size. For example, as the exposure time increases, the average diameter of catalyst nanoparticles 42 may increase.

At step 106, a gas or plasma enhanced CVD process is performed to facilitate growth of one or more carbon nanotubes 32 from a corresponding catalyst nanoparticle 42. In one embodiment, catalyst nanoparticles 42 (and after carbon nanotubes 32 begin growing from catalyst nanoparticles 42, the growing portion of carbon nanotubes 32) may be exposed to carbon containing gases or plasma at elevated temperatures. The length of time the growing carbon nanotubes 32 are exposed to the gas or plasma under such conditions typically determines the ultimate height of carbon nanotubes 32. In one embodiment, carbon nanotubes 32 grow substantially perpendicular to active region 22, one or more carbon nanotubes 32 being coupled to a corresponding catalyst nanoparticle 42 at first ends 44 of carbon nanotubes 32, and include both single-walled carbon nanotubes 32a and multi-walled carbon nanotubes 32b. At step 108, barrier material 34b may be deposited over contact structure 40 such that it substantially surrounds second ends 48 of carbon nanotubes 32, possibly extending into via 24 so as to substantially surround second ends 48 even of any carbon nanotubes 32 whose second ends 48 do not project out of via 24. At step 110, second conductive material 34a may be deposited over contact structure 40 to provide electrical conductivity between contact structure 40 and one or more other semiconductor devices within the associated integrated circuit. In one embodiment, seepage of second conductive material 34a into dielectric 26 is substantially prevented by the presence of barrier material 34b.

Although the present invention has been described with several embodiments, diverse changes, substitutions, variations, alterations, and modifications may be suggested to one skilled in the art, and it is intended that the invention encompass all such changes, substitutions, variations, alterations, and modifications as fall within the scope of the appended claims.

## Claims

1. A semiconductor device within an integrated circuit, comprising:
an active region associated with a contact structure of the semiconductor device;
a conductive layer providing electrical conductivity between the contact structure of the semiconductor device and one or more other semiconductor devices within the integrated circuit; and
a plurality of carbon nanotubes coupled to the active region at first ends of the carbon nanotubes, coupled to the conductive layer at second ends of the carbon nanotubes, and extending within a via of the contact structure from the active region to the conductive layer to provide electrical conductivity between the active region and the conductive layer.

2. The device of Claim 1, further comprising a plurality of catalyst nanoparticles deposited on the active region to facilitate growth of the carbon nanotubes during fabrication of the integrated circuit, one or more carbon nanotubes being grown from a corresponding catalyst nanoparticle.

3. The device of Claim 2, wherein the active region comprises a conductive material deposited on a substrate at the bottom of the via, the catalyst nanoparticles being coupled to the conductive material, the conductive material facilitating formation of the catalyst nanoparticles on the active region during fabrication of the integrated circuit.

4. The device of Claim 3, wherein:
the conductive layer comprises copper;
the catalyst nanoparticles comprise at least one of cobalt and nickel; and
the conductive material comprises tungsten.

5. A method for constructing a semiconductor device in an integrated circuit, comprising:
defining an active region and a via associated with a contact structure of the semiconductor device;
growing a plurality of carbon nanotubes on the active region within the via of the contact structure, the carbon nanotubes being coupled to the active region at first ends of the carbon nanotubes; and
depositing a conductive layer over the contact structure, the carbon nanotubes being coupled to the conductive layer at second ends of the carbon nanotubes and extending within a via of the contact structure from the active region to the conductive layer to provide electrical conductivity between the active region and the conductive layer, the conductive layer providing electrical conductivity between the contact structure of the semiconductor device and one or more other semiconductor devices within the integrated circuit.

6. A digital signal processor (DSP) comprising a plurality of contact structures that each comprise:
an active region and an associated via;
a conductive layer providing electrical conductivity between the contact structure and one or more other contact structures within the DSP;
a plurality of catalyst nanoparticles deposited on the active region to facilitate growth of carbon nanotubes during fabrication of the DSP, one or more carbon nanotubes being grown from a corresponding catalyst nanoparticle; and
a plurality of multi-walled and a plurality of single-walled carbon nanotubes coupled to corresponding catalyst nanoparticles at first ends of the carbon nanotubes, coupled to the conductive layer at second ends of the carbon nanotubes, and extending within the via from the active region to the conductive layer to provide electrical conductivity between the active region and the conductive layer.

7. The DSP of Claim 6, wherein the active region comprises a conductive material deposited on a substrate at the bottom of the via, the catalyst nanoparticles being coupled to the conductive material, the conductive material facilitating formation of the catalyst nanoparticles on the active region during fabrication of the DSP.

8. The DSP of Claim 7, wherein:
the conductive layer comprises copper;
the catalyst nanoparticles comprise at least one of cobalt and nickel; and
the conductive material comprises tungsten.

9. The DSP of Claim 7, wherein the conductive layer comprises:
a barrier material deposited on a dielectric material surrounding the via; and
a conductive material deposited on the barrier material;
the barrier material extending into the via and substantially surrounding the second ends of at least some of the carbon nanotubes, the barrier material substantially preventing seepage of the conductive material into the dielectric material.
